# EUROPÄISCHE PATENTSCHRIFT

(11) **EP 1 864 556 B1**
(45) Veröffentlichungstag und Bekanntmachung des Hinweises auf die Patenterteilung: **16.05.2018**
(21) Anmeldenummer: 06722702.5
(22) Anmeldetag: 28.03.2006
(51) Int. Cl.: H05K 1/02, H01H 37/76

(54) **ELEKTRONISCHE BAUGRUPPE**
ELECTRONIC ASSEMBLY
MODULE ELECTRONIQUE

(30) Priorität: 31.03.2005 DE 102005014601
(43) Veröffentlichungstag der Anmeldung: 12.12.2007
(73) Patentinhaber: Conti Temic Microelectronic GmbH, 90411 Nürnberg (DE)
(72) Erfinder: SCHLENKER, Roberto, 85092 Kösching (DE); NAGEL, Michael, 90455 Nürnberg (DE); MARTIN, Jürgen, D-79733 Görwihl (DE)
(86) Internationale Anmeldenummer: PCT/DE2006/000550
(87) Internationale Veröffentlichungsnummer: WO 2006/102876

(56) Entgegenhaltungen:
- WO-A1-93/26028
- WO-A1-96/03761
- US-A- 5 770 993
- US-A- 5 896 080
- US-A- 5 999 391

## Beschreibung

Die Erfindung bezieht sich auf eine elektronische Baugruppe mit einer Leiterplatte, die mit Leiterbahnen versehen und zur Bildung einer elektronischen Schaltung unter Verwendung eines geeigneten Lots mit einer Anzahl von SMD-("Surface Mounted Device")-Bauelementen und/oder weiteren elektronischen und/oder elektromechanischen Bauteilen bestückt ist. Weiter bezieht sich die Erfindung auf die Verwendung der elektronischen Baugruppe in einem ABS/ESP-System eines Kraftfahrzeugs, ein Verfahren zur Herstellung der Baugruppe und einen Kontaktbügel geeignet für die Verwendung in einer Baugruppe.

Derartige elektronische Baugruppen können insbesondere für einen Einsatz in elektronischen Steuergeräten, beispielsweise in Fahrdynamikreglern, ESP-Systemen oder ABS-Reglern, vorgesehen sein. Je nach Anwendungszweck könnte bei derartigen Baugruppen durch fehlerhafte Bauteile wie beispielsweise Schalttransistoren, durch Leiterplattenschluss oder durch Wassereintritt eine unzulässig hohe Verlustleistung in der Baugruppe auftreten. Diese Verlustleistung könnte in schweren Fällen zur vollständigen Zerstörung der Leiterplatte. WO 93/26028 A1 offenbart ein Federbügel der als Thermosicherung dient.

Der Erfindung liegt daher die Aufgabe zugrunde, eine elektronische Baugruppe der oben genannten Art anzugeben, die mit einfachen Mitteln in besonders hohem Maße gegen eine mögliche Entstehung von hoher Verlustleistung abgesichert ist.

Diese Aufgabe wird erfindungsgemäß gelöst, indem eine Anzahl von Verbindungen zwischen Leiterbahnen, Bauelementen und/oder Bauteilen auf der Leiterplatte über jeweils einen federbelasteten Kontaktbügel hergestellt ist.

Die Erfindung geht dabei von der Überlegung aus, dass eine in besonders hohem Maße gegen eine Verlustleistungsentstehung abgesicherte Baugruppe für eine möglichst sofortige und selbsttätige Unterdrückung und Beseitigung ausgelegt sein sollte. Dabei sollte bei den durch die Verlustleistung auftretenden erhöhten Temperaturen unmittelbar die zur Brandentstehung beitragende erhöhte Verlustleistung defekter Bauelemente oder dergleichen schnellstmöglich eliminiert werden. Daher sollte für ein schnelles Abschalten des elektrischen Stromes eine Sicherung vorgesehen sein, die bei erhöhten Temperaturen von beispielsweise mehr als etwa 180 °C sprungartig die elektrische Verbindung zwischen den betroffenen Leiterbahnen und/oder Bauelementen oder Bauteilen unterbricht. Um dies zu ermöglichen, wird die Erkenntnis genutzt, dass beim Auftreten derartig erhöhter Temperaturen die bei der Montage von Bauteilen oder dergleichen auf der Leiterplatte verwendeten Lotmaterialien üblicherweise zu schmelzen beginnen. Um dies zu den genannten Sicherungszwecken auszunutzen, sollte die Leiterplatte mit Kontaktbügeln versehen sein, die beim Schmelzen des Lotmaterials die Verbindung zwischen Leiterbahnen oder dergleichen unterbrechen. Zu diesem Zweck sind die Kontaktbügel federbelastet ausgeführt, so dass bei Nachlassen der mechanischen Verbindung infolge der Erweichung des Lots aufgrund der vorgehaltenen Federkraft ein selbsttätiges Lösen der Verbindung durch den jeweiligen Kontaktbügel eintritt. Der Kontaktbügel enthält dabei ein federndes Element, das den Kontaktbügel sprungartig von der Leiterplatte trennt, sobald das verwendete Lot eine Mindestfestigkeit unterschreitet.

Der Kontaktbügel könnte dabei auch unter Verwendung anderer geeigneter Materialien montiert sein, durch die sichergestellt ist, dass bei Erreichen oder Überschreiten einer vorgebbaren Mindesttemperatur die mechanische Verbindung zum Kontaktbügel gelöst wird und somit dieser zur Unterbrechung der stromseitigen Verbindung öffnen kann. Vorzugsweise ist der Kontaktbügel aber unter Verwendung des für die Montage der Bauelemente auf der Leiterplatte verwendeten Lots montiert, so dass dessen eintretendes Schmelzen bei ausreichend hohen Temperaturen zur Auslösung der Sicherungsfunktion über den Kontaktbügel herangezogen werden kann.

Um eine zuverlässige bedarfsweise Unterbrechung der durch den Kontaktbügel hergestellten elektrischen Verbindung zwischen den jeweiligen Leiterbahnen und/oder Bauteilen zu gewährleisten, ist der Kontaktbügel vorteilhafterweise mit einer ausreichend hohen Federkraft belastet. Der Kontaktbügel ist federnd gefertigt und mit innerer Vorspannung montiert. Bei einer derartigen Ausgestaltung ist ein besonders einfacher Aufbau ermöglicht, insbesondere da über den Kontaktbügel hinaus keine weiteren separaten Komponenten erforderlich sind. Der Kontaktbügel kann dabei derart ausgestaltet sein, dass er bereits bei der Montage seine innere Vorspannung erhält. Um den Kontaktbügel aber auch in SMD-Technologie montieren zu können, sollte die Montage des Kontaktbügels auf der Leiterplatte ohne zusätzliche Verspannungskräfte oder dergleichen möglich sein. Dazu ist der Kontaktbügel vorteilhafterweise federnd gefertigt und für eine spannungslose Montage ausgelegt, wobei eine innere Vorspannung nach der Montage durch geeignete Verformung des Kontaktbügels aufgebracht wird.

Für eine besonders zuverlässige Sicherungsfunktion ist die elektronische Baugruppe vorteilhafterweise derart ausgelegt, dass bei Auftreten einer unerwarteten Temperaturerhöhung gezielt die Stromversorgung zur Leiterplatte oder zu einzelnen Bauteilen unterbrochen wird, da somit die Verlustleistung besonders wirkungsvoll und kurzfristig reduziert werden kann. Um dies zu gewährleisten, ist zumindest einer der Kontaktbügel vorteilhafterweise an einer Versorgungsleiterbahn montiert, über die eine Stromeinspeisung oder -zuführung zu den auf der Leiterplatte montierten Bauteilen erfolgt.

Für einen besonders gering gehaltenen Herstellungsaufwand der Baugruppe sind deren Komponenten und insbesondere auch die Kontaktbügel vorteilhafterweise für eine Montierbarkeit unter Rückgriff auf übliche Löt- und Bestückungsverfahren ausgelegt.Um dabei insbesondere auf herkömmliche und kostengünstige Bestückungskonzepte zurückgreifen zu können, ist der oder jeder Kontaktbügel vorteilhafterweise derart gestaltet, dass er in einem automatisierten Bestückungsprozess einsetzbar ist. Dazu ist der jeweilige Kontaktbügel vorteilhafterweise derart geformt, dass er wie an sich bekannte SMD-Bauteile gegurtet oder magaziniert einem herkömmlichen Bestückungsautomat zugeführt werden kann.

Aufgrund der erreichbaren hohen Sicherheitsstandards der elektronischen Baugruppe gegenüber hohen Verlustleistungen und dadurch bedingten Schäden, wie beispielsweise Zerstörung der Leiterplatte ist die Baugruppe besonders zum Einsatz in einem Kraftfahrzeug geeignet. Vorteilhafterweise wird die elektronische Baugruppe dabei in einem ABS- oder ESP-System eines Kraftfahrzeugs verwendet.

Die mit der Erfindung erzielten Vorteile bestehen insbesondere darin, dass durch die Anbringung von federbelasteten Kontaktbügeln zur Herstellung elektrischer Verbindungen zwischen Leiterbahnen und/oder Bauteilen auf der Leiterplatte beim Auftreten erhöhter Temperaturen ein Aufschmelzen der Verbindungsstelle des Kontaktbügels zur Leiterplatte und damit einhergehend durch die federnde Ausgestaltung eine abrupte Unterbrechung der durch den Kontaktbügel hergestellten elektrischen Verbindung erreichbar ist. Damit kann auf der Baugruppe zuverlässig, abrupt und schnell die Energiezufuhr zur Leiterplatte insgesamt oder zu einzelnen Bauteilen unterbrochen werden, sobald eine unerwartete Temperaturerhöhung eintritt. Damit sind Folgeschäden infolge erhöhter Verlustleistung in der Baugruppe sicher vermieden. Die Erfindung wird anhand der Figuren näher erläutert. Darin zeigen:
- Fig. 1: schematisch eine elektronische Baugruppe, die nicht Teil der Erfindung ist; Fig. 2 Montage des Kontaktbügels auf der Leiterplatte; und

- Fig. 3a,b: Kontaktbügel der Leitplatte nach Fig. 2 im Detail.
Gleiche Teile sind in allen Figuren mit denselben Bezugszeichen versehen.

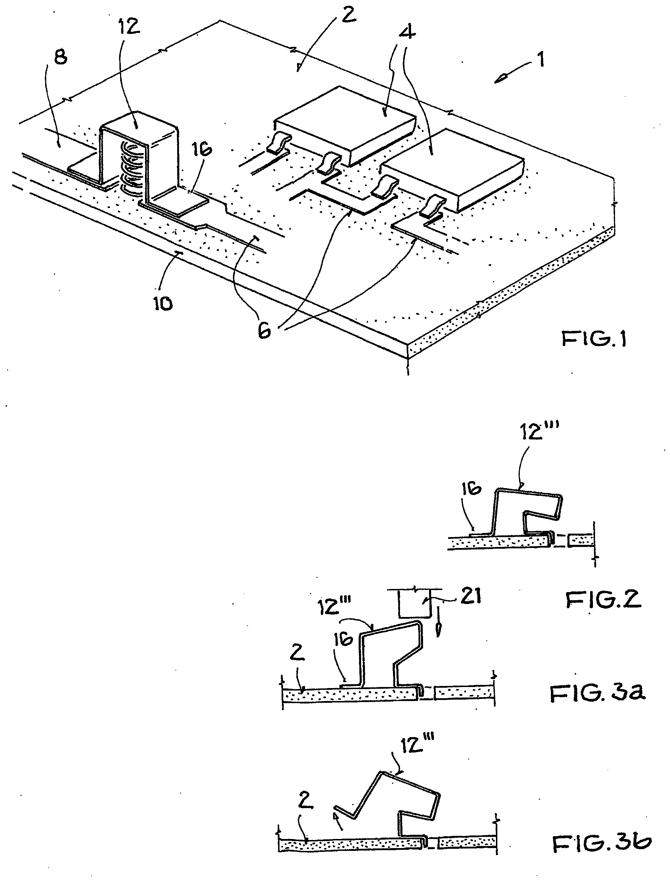

Die in Fig. 1 schematisch dargestellte elektronische Baugruppe 1 ist insbesondere zum Einsatz in elektronischen Steuergeräten, wie beispielsweise in Fahrdynamikreglern, ABS-Reglern, ESP-Systemen oder anderen Fahrzeugsteuergeräten eines Kraftfahrzeugs, vorgesehen. Sie umfasst eine Leiterplatte 2, die mit einer Anzahl anwendungsspezifisch ausgestalteter SMD-Bauelemente 4 und weiteren elektronischen und/öder elektromechanischen Bauteilen bestückt ist. Die SMD-Bauelemente 4 und gegebenenfalls die weiteren Bauteile sind unter Verwendung eines geeigneten Lots auf der Leiterplatte 2 montiert und über eine Vielzahl von Leiterbahnen 6, von denen im Ausführungsbeispiel lediglich einige exemplarisch dargestellt sind, geeignet miteinander verbunden.

Die Leiterplatte 2 kann dabei als einfache Leiterplatte oder auch als Leiterplatte mit mehreren Verdrahtungsebenen, wie beispielsweise als Zwei-, Vier- oder Mehrfachlayer, ausgestaltet sein. Zur Bespeisung der aktiven Komponenten mit Spannung und/oder Strom weist die Leiterplatte 2 zudem eine Anzahl von Leiterbahnen 6 auf, die als so genannte Versorgungsleiterbahnen 8 ausgestaltet sind. Diese sind insbesondere zum Anschluss einer externen Spannungsversorgung geeignet ausgebildet. Im Hinblick auf diesen Einsatzzweck sind die Versorgungsleiterbahnen 8 insbesondere hinsichtlich ihres Materials und ihrer Dimensionierung geeignet gewählt.

Die Leiterplatte 2 ist aufgrund ihrer Auslegung gegen eine mögliche Entstehung hoher Verlustleistungen abgesichert. Zu diesem Zweck ist eine Anzahl von Verbindungen zwischen Leiterbahnen 6, Bauelementen 4 und/oder Bauteilen über jeweils einen federbelasteten Kontaktbügel 12 hergestellt, von denen in Fig. 1 lediglich einer dargestellt ist. Selbstverständlich können je nach Bedarf, Auslegung und Architektur der Baugruppe 1 aber auch noch weitere Kontaktbügel 12 an geeigneten Stellen der Leiterplatte 2 positioniert sein. Der Kontaktbügel 12 ist unter Verwendung des auch zur Montage der Bauelemente 4 und weiteren Bauteile verwendeten Lots auf der Leiterplatte 2 montiert. Damit ist sichergestellt, dass bei auftretenden Temperaturen von mehr als der Schmelztemperatur dieses Lots (beispielsweise etwa 180 °C) die Festigkeit der Verbindung des Kontaktbügels 12 mit der Leiterplatte 2 gravierend absinkt. Durch die Belastung des Kontaktbügels 12 mit einer geeigneten Vorspannung tritt in diesem Fall ein sprungartiges Lösen des Kontaktbügels 12 von der Leiterplatte 2 auf, so dass die durch den Kontaktbügel 12 hergestellte Verbindung instantan unterbrochen wird. Im Ausführungsbeispiel nach Fig. 1, in dem der dort gezeigte Kontaktbügel 12 in eine Versorgungsleiterbahn 8 geschaltet ist, wird in diesem Fall somit unmittelbar die Stromversorgung der Leiterplatte 2 unterbrochen, so dass hohe Verlustleistungen sofort unterbunden werden. In Fig. 2 ist die Montage des Kontaktbügels 12''' auf der Leiterplatte 2 gemäß der Erfindung schematisch dargestellt.

Der Kontaktbügel 12"' wird vorspannungslos hergestellt, so dass er in besonders einfacher Weise auch in SMD-Technologie montierbar ist. Anschließend wird der Kontaktbügel 12"' zur Herstellung der gewünschten Federbelastung oder Vorspannung im bereits montierten Zustand verformt, wobei beispielsweise ein geeignet positionierter Pressstempel herangezogen werden kann.

Fig. 3a zeigt den Kontaktbügel 12"' unmittelbar vor seiner Montage. Der Kontaktbügel 12"' ist dabei bereits auf der Leiterplatte 2 befestigt, weist aber noch seine unverformte Grundform auf. In diesem Zustand kann der Kontaktbügel 12"' ohne Vorspannung und dementsprechend ohne nennenswerte externe Kräfte auf die Leiterplatte 2 aufgelötet werden. Um dem Kontaktbügel 12"' anschließend die zu Sicherungszwecken gewünschte Vorspannung aufzuprägen, wird er über einen Preßstempel 21 geeignet verformt. Dazu wird der Preßstempel 21 geeignet in Richtung des dargestellten Pfeils bewegt.

Fig. 3b zeigt hingegen die Kontaktbügel 12" und 12"' nach dem Auslösefall, also nachdem unerwünscht hohe Temperaturen aufgetreten sind. Dies führte zu einem Anschmelzen des Lots, mit dem die Kontaktbügel 12", 12"' jeweils auf der Leiterplatte 2 fixiert sind. Infolge der aufgeprägten Vorspannung hält diese Befestigung bei einem Erweichen des Lots nicht mehr stand, so dass der Kontaktbügel 12", 12"' jeweils sprungartig löst und die von ihm hergestellte elektrische Verbindung unterbricht.

### Bezugszeichenliste

- 1: elektronische Baugruppe
- 2: Leiterplatte
- 4: SMD-Bauelement
- 6: Leiterbahn
- 8: Versorgungsleiterbahn
- 10: Grundkörper
- 12,12"': Kontaktbügel
- 16: Enden
- 21: Preßstempel

## Patentansprüche

1. Elektronische Baugruppe (1) mit einer Leiterplatte (2), die mit Leiterbahnen (6) versehen und zur Bildung einer elektronischen Schaltung unter Verwendung eines geeigneten Lots mit einer Anzahl von SMD-Bauelementen (4) und/oder weiteren elektronischen und/oder elektromechanischen Bauteilen bestückt ist, wobei eine Anzahl von Verbindungen zwischen Leiterbahnen (6), Bauelementen und/oder Bauteilen über jeweils einen federbelasteten Kontaktbügel (12"') hergestellt ist, wobei
der Kontaktbügel einstückig ausgebildet und geeignet geformt ist für eine vorspannungslose Montage über einen Bestückungsautomaten, und eine anschließende Verformung des Kontaktbügels zur Herstellung der gewünschten Federbelastung bzw. Vorspannung, **dadurch gekennzeichnet, dass** die Form des Kontaktbügels im montierten und verspannten Zustand der in Figur 2 gezeigten Form entspricht.

2. Elektronische Baugruppe (1) nach Anspruch 1, bei der der jeweilige Kontaktbügel (12'") unter Verwendung des Lots **SMD**-montiert ist.

3. Elektronische Baugruppe (1) nach Anspruch 1 oder 2, bei der zumindest einer der Kontaktbügel (12'") an einer Versorgungsleiterbahn (8) montiert ist.

4. Verwendung einer elektronischen Baugruppe (1) nach einem der Ansprüche 1 bis 3 in einem ABS/ESP-System eines Kraftfahrzeugs

5. Verfahren zur Herstellung eines federbelasteten Kontaktbügels (12"') auf eine Leiterplatte (2) einer elektronischen Baugruppe (1) mit folgenden Schritten:
- vorspannungsloses Herstellen des Kontaktbügels wobei der Kontaktbügel im vorspannungsfreien Zustand der Form gemäß Figur 3a entspricht,
- Bestücken der Leiterplatte mit dem Kontaktbügel (12"'),
- Auflöten des Kontaktbügels auf die Leiterplatte,
- anschließende Verformung des Kontaktbügels zur Erzeugung einer Federbelastung bzw. Vorspannung mittels eines Pressstempels (21), wobei die Form des Kontaktbügels im montierten und verspannten Zustand der in Figur 2 gezeigten Form entspricht.

6. Kontaktbügel (12"') geeignet für die Verwendung in einer Baugruppe nach einem der Ansprüche 1-3, wobei der Kontaktbügel (12'") im vorspannungsfreien Zustand der Form gemäß Figur 3a entspricht.

## Claims

1. Electronic assembly (1) with a circuit board (2), which is provided with conductor strips (6) and, for forming an electronic circuit, is equipped with a number of SMD components (4) and/or further electronic and/or electromechanical component parts by using a suitable solder, a number of connections between conductor strips (6), components and/or component parts being produced by means of in each case a spring-loaded contact bridge (12"'), the contact bridge being formed in one piece and suitably shaped for mounting without prestress by means of an automatic placement machine, and subsequent deformation of the contact bridge to produce the desired spring loading or prestressing, **characterized in that** the shape of the contact bridge in the mounted and stressed state corresponds to the shape shown in Figure 2.

2. Electronic assembly (1) according to Claim 1, in which the respective contact bridge (12"') is SMD-mounted by using the solder.

3. Electronic assembly (1) according to Claim 1 or 2, in which at least one of the contact bridges (12"') is mounted on a power-supply conductor strip (8).

4. Use of an electronic assembly (1) according to one of Claims 1 to 3 in an ABS/EPS system of a motor vehicle.

5. Method for producing a spring-loaded contact bridge (12"') on a circuit board (2) of an electronic assembly (1) with the following steps:
- producing the contact bridge without prestress, the contact bridge in the unprestressed state corresponding to the shape according to Figure 3a,
- placing the contact bridge (12"') on the circuit board,
- soldering the contact bridge onto the circuit board,
- subsequently deforming the contact bridge to produce spring loading or prestressing by means of a pressing ram (21),
the shape of the contact bridge in the mounted and stressed state corresponding to the shape shown in Figure 2.

6. Contact bridge (12"') suitable for use in an assembly according to one of Claims 1 to 3, the contact bridge (12"') in the unprestressed state corresponding to the shape according to Figure 3a.

## Revendications

1. Module électronique (1) comprenant une carte de circuits imprimés (2), pourvue de pistes conductrices (6) et équipée d'un certain nombre de composants montés en surface (SMD) (4) et/ou d'autres composants électroniques et/ou électromécaniques pour former un circuit électronique par utilisation d'une soudure appropriée, dans lequel un certain nombre de connexions entre des pistes conductrices (6), des composants et/ou des parties constitutives sont établies par l'intermédiaire d'un étrier de contact (12'") respectif soumis à l'action d'un ressort, dans lequel l'étrier de contact est réalisé en une seule pièce et est formé de manière appropriée pour un montage non contraint au moyen d'un automate d'implantation, puis pour une déformation de l'étrier de contact afin d'établir l'action de ressort ou la précontrainte souhaitée, **caractérisé en ce que** la forme de l'étrier de contact à l'état monté et précontraint correspond à la forme représentée sur la figure 2.

2. Module électronique (1) selon la revendication 1, dans lequel l'étrier de contact (12'") respectif est soumis à un montage de type SMD par utilisation de la soudure.

3. Module électronique (1) selon la revendication 1 ou 2, dans lequel au moins l'un des étriers de contact (12'") est monté sur une piste conductrice d'alimentation (8) .

4. Utilisation d'un module électronique (1) selon l'une des revendications 1 à 3 dans un système ABS/ESP d'un véhicule automobile.

5. Procédé de réalisation d'un étrier de contact (12'") soumis à l'action d'un ressort sur une carte de circuits imprimés (2) d'un module électronique (1), comportant les étapes consistant à :
- réaliser sans précontrainte l'étrier de contact, dans lequel l'étrier de contact à l'état non précontraint correspond à la forme représentée sur la figure 3a,
- équiper la carte de circuits imprimés de l'étrier de contact (12'"),
- souder l'étrier de contact sur la carte de circuits imprimés,
- déformer ensuite l'étrier de contact afin de créer une action de ressort ou une précontrainte au moyen d'un piston de presse (21),
dans lequel la forme de l'étrier de contact à l'état monté et non contraint correspond à la forme représentée sur la figure 2.

6. Étrier de contact (12'") approprié pour une utilisation dans un module selon l'une des revendications 1-3, dans lequel l'étrier de contact (12'") à l'état non précontraint correspond à la forme représentée sur la figure 3a.
